Europäisches Patentamt

European Patent Office

Office européen des brevets

(11) Publication number: **0 214 050 B1**

# EUROPEAN PATENT SPECIFICATION

(45) Date of publication of patent specification: **14.08.91**    (51) Int. Cl.⁵: **G11C 7/00**

(21) Application number: **86401865.0**

(22) Date of filing: **22.08.86**

---

(54) **Parallel row-to-row data transfer in random access memories.**

---

(30) Priority: **30.08.85 US 771317**

(43) Date of publication of application:
**11.03.87 Bulletin 87/11**

(45) Publication of the grant of the patent:
**14.08.91 Bulletin 91/33**

(84) Designated Contracting States:
**AT DE FR GB IT NL**

(56) References cited:
**EP-A- 0 049 990**
**US-A- 4 193 127**
**US-A- 4 366 503**

(73) Proprietor: **SGS-THOMSON MICROELECTRON-ICS, INC. (a Delaware corp.)**
**1310 Electronics Drive**
**Carrollton, TX 75006(US)**

(72) Inventor: **Antaki, Patrick R.**
**THOMSON-CSF SCPI 19, avenue de Messine**
**F-75008 Paris(FR)**
Inventor: **Davis, Harold L.**
**THOMSON-CSF SCPI 19, avenue de Messine**
**F-75008 Paris(FR)**

(74) Representative: **Driver, Virginia Rozanne et al**
**Page White & Farrer 54 Doughty Street**
**GB-London WC1N 2LS(GB)**

## Description

The invention addressed herein is directed toward the technical field of semiconductor memory devices, and more particularly toward row-to-row data transfer techniques in semiconductor random access memory (RAM) devices.

According to presently known techniques, in order to transfer an entire row of data on a semiconductor chip memory to another selected row, considerable steps of software control are required. In particular, a host processor or other special hardware would be required to conduct the transfer. Further, the transfer, even when successfully implemented, would be relatively slow and cumbersome.

Developing effective techniques for intra-memory data transfer is becoming increasingly important as memory sizes continue to increase. In particular, the market for RAM memory chips has already effectively shifted from 64K memory products to the larger 256K memory chip size. Future memory chip lines are projected to include 512K and 1M bit capacities. The invention herein is of course intended to be applicable to row-to-row data transfer in both existing and future RAM memory products.

US-A-4,193,127 describes a memory of the type in which each memory cell has separate input and output terminals and is connected between a pair of bit lines and a pair of word lines. Data from a selected row of the memory is simultaneous read out by sensing the voltage difference across the bit lines while this voltage differential is fed back from the pair of bit lines through a switching circuit which can then apply the data to a second selected row. In this way, data can be transferred between rows. However, this memory structure utilises more space and power than memory structures with which the present invention is concerned, in which each memory cell has a single input/output port so that there is a memory cell located at each combination of row and column lines. It is an object of the present invention to provide a method of transferring data between rows in this type of memory structure so that an entire word or row of bits in a semiconductor memory can be transferred to a second selected row location of the same memory chip without external support in the nature of a host processor or other special hardware.

According to the invention there is provided a method of transferring data from a selected first row to a selected second row in a semiconductor memory device comprising an array of memory cells connected in a matrix of mutually perpendicular, respectively parallel row and parallel column lines said method comprising the steps of:

a) activating a first row line associated with memory cells containing data to be transferred to place on the column lines data to be transferred to memory cells associated with a selected second row line; and

(b) activating a second selected row to receive the data from said column lines for transfer to the memory cells associated with said second row line, characterized in that the method is applied in a memory device in which each of the column lines is connected at one end to one of a plurality of sense amplifiers effective for amplifying and latching the data of corresponding memory cells of said selected first row onto the column lines associated with said sense amplifiers, each of the said memory cells being associated with a single combination of said row and column lines, and in that the method further comprises, after step a) and before step b) latching and amplifying the data from the memory cells of said first selected row line onto the respective column lines using the sense amplifiers of said memory device.

According to one version of the invention, the first row line is deactivated prior to activating the second row lines, as will be seen.

For a better understanding of the present invention and to show how the same may be carried into effect, reference will now be made by way of example to the accompanying drawings, in which:-

Figure 1 is a schematic drawing of a portion of a memory chip in which row-to-row data transfer is to be accomplished according to a preferred version of the invention addressed herein;

Figure 2 is a timing diagram disclosing the sequence of operation by which the data of one row of memory cells is transferred to the memory cells associated with another selected row; and

Fig. 3 is a simplified flow chart of the steps which are undertaken to implement the data transfer proposed under the invention herein.

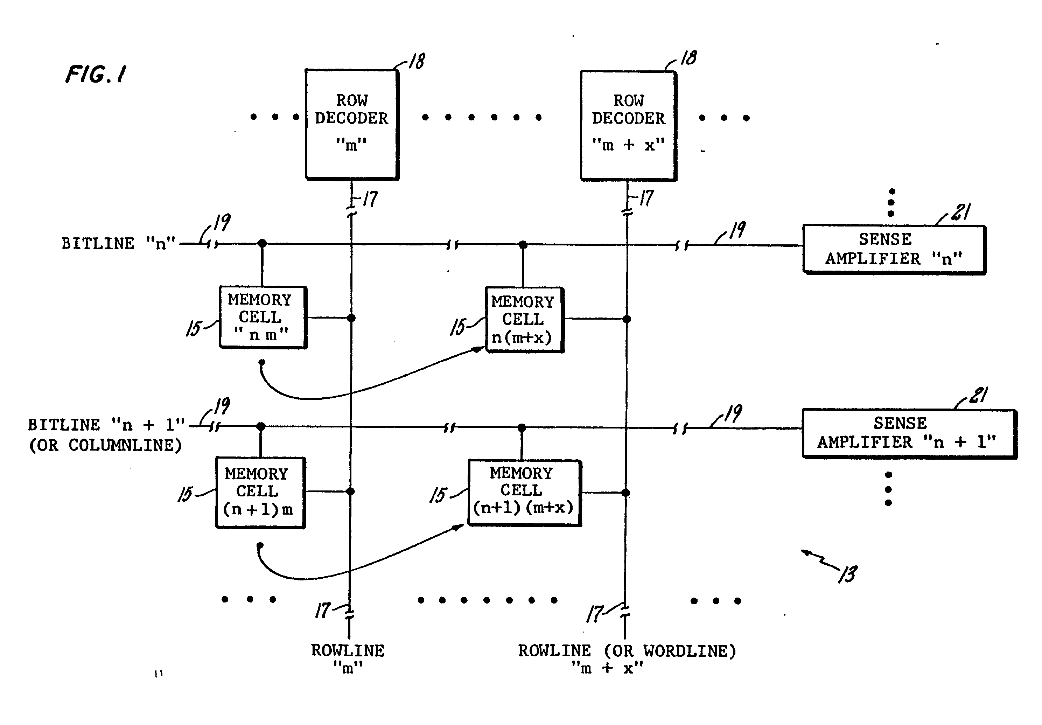

Fig. 1 shows a portion of a memory array 13 in a semiconductor chip random access memory (RAM) including a plurality of memory cells 15 arranged in matrix form along "x" and "y" axes of the standard Cartesian reference frame.

The memory array 13 in the matrix includes a plurality of substantially parallel vertical rows or row lines 17 connected to row decoder elements 18. Each of the vertical rows 17 is associated with a word of information, i.e. data, in terms of the bits stored in respective memory cells 15 connected therewith.

Substantially perpendicular to the row lines 17 are a plurality of substantially parallel horizontal column or bit lines 19 which are associated with the same plurality of memory cells 15, each memory cell 15 being associated with each combination of row and column lines, respectively 17 and 19.

Further, each of the horizontal bit or column lines 19 is connected with one of output elements which are well-known components such as sense amplifiers 21.

In order to transfer or copy the contents of the memory cells 15 associated with a selected one of rows 17 to those of another selected row 17, e.g. row "m" onto row "m + x" of memory array 13, a first rowline "m" is activated. This transfer is suggested by the curved arrows on Fig. 1.

Next, sensing operation is conducted, whereby the sense amplifiers 21 sense, amplify and latch the data on column lines 19. At this point, a desired element of data in question is available to be used on each column line.

The above evolution is typical of a standard RAM access cycle whether static or dynamic.

According to the invention, it is next desired to activate a second selected row line 17, e.g. row "m + x", and the memory cells 15 associated therewith. This second row line 17, in being accessed, connects each one of the memory cells 15 associated with respective row line "m + x" with each connected column line and receives the latched data therefrom.

Thus, the contents of the column lines 19 are effectively written into the memory cells 15 of row "m + x", thereby accomplishing the desired copying evolution.

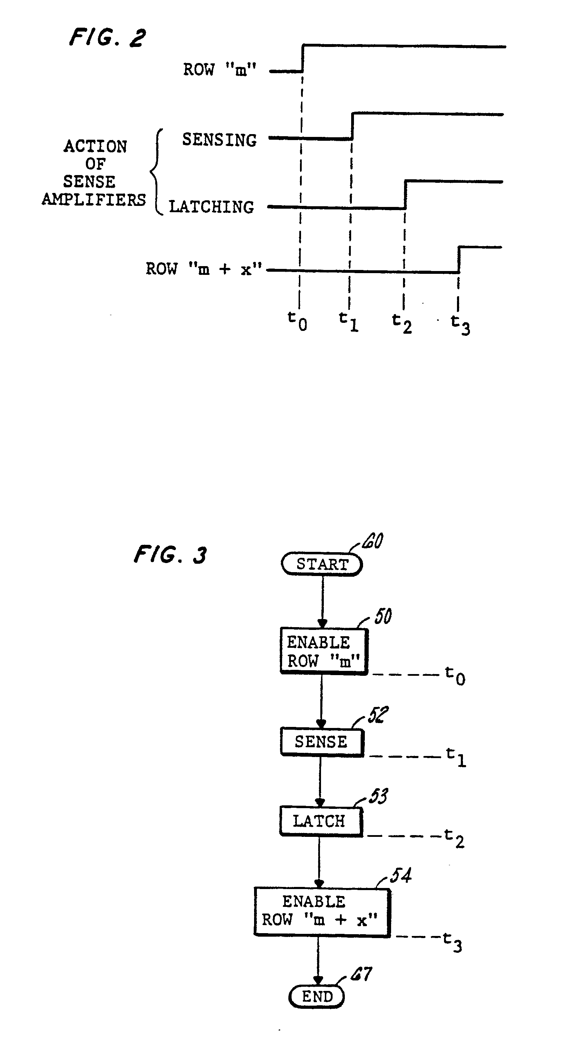

Fig. 2 shows the timing relationship, or sequence of events with respect to time in order for the row-to-row transfer to occur. In particular, Fig. 2 shows the time of activation of row "m" at the beginning of operation. This is followed by sense amplifiers 21 amplifying the data to be transferred on column lines 19.

Next, sense amplifier latching proceeds, thereby establishing the validity of the data present on the respective column lines 19.

Row "m" can be left activated even after the second selected line "m + x" is activated or turned off. Alternatively, row "m" can be deactivated before activating row "m + x". In a one cycle memory evolution, both the transferor and transferee row lines 17 are turned off at the same time. However, some memory devices use two-cycle memory cycles. In these, the first row line 17 is turned off before the second row line 17 is turned on. This invention works in both kinds of memory devices.

Fig. 3 is another representation of these actions taken for accomplishing the desired transfer or copying from row "m" onto row "m + x".

In particular, block 50 indicates the activation of row "m" at time "$t_0$"; block 52 indicates sensing action by sense amplifiers 21 of the data on the several bit or column lines 19 at time "$t_1$"; block 53

suggests the latching of this information on respective sense amplifiers 22 at "$t_2$"; and finally the enablement of row "m + x" is shown at block 54 to indicate reception of the word by the respective memory cells 15 in row "m + x" at time "$t_3$". Starting and ending operation of this sequence are suggested by oval compartments 60 and 67.

The speed of this data transfer evolution according to the invention is particularly swift and effective, in that it typically takes no more time to accomplish than is required to conduct a single access of the RAM itself. Under present techniques involving a similar one of such transfers under software direction, the time to perform the operation is likely to be orders of magnitude longer than required according to the invention herein.

The above technique also permits the accomplishment of so-called non-destructive data swaps. In the above example, the data formerly in row "m + x" has been eliminated or destroyed from memory. In a non-destructive data swap, the original data in row "m" is first stored at another temporary row before the new data is transferred in, thereby effectively preserving it for other use.

The contents herein are likely to cause others skilled in the art to which this invention relates to conceive of other versions of the invention, which are nonetheless a part thereof. Accordingly, it is urged that reference be taken to the claims which follow, as these alone authoritatively set forth the scope of the invention addressed herein.

## Claims

1. A method of transferring data from a selected first row (m) to a selected second row (m + x) in a semiconductor memory device comprising an array of memory cells (15) connected in a matrix of mutually perpendicular, respectively parallel row (17) and parallel column (19) lines said method comprising the steps of:

   a) activating a first row line (m) associated with memory cells containing data to be transferred to place on the column lines data to be transferred to memory cells associated with a selected second row line (m + x); and

   (b) activating a second selected row to receive the data from said column lines for transfer to the memory cells associated with said second row line, characterized in that the method is applied in a memory device in which each of the column lines is connected at one end to one of a plurality of sense amplifiers (21) effective for amplifying and latching the data of corresponding memory cells of said selected first row (m) onto the column lines associated with said sense amplifiers, each of the said memory cells (15) being associated with a single combination of said row and column lines, and in that the method further comprises, after step a) and before step b) latching and amplifying the data from the memory cells of said first selected row line onto the respective column lines using the sense amplifiers (21) of said memory device.

2. The method of claim 1, wherein said first selected row line is deactivated before activating said second selected row line.

**Revendications**

1. Procédé de transfert de données entre une première rangée choisie (m) et une seconde rangée choisie (m + x) dans un dispositif de mémoire à semiconducteur comprenant une matrice de cellules mémoire (15) connectées matriciellement selon des lignes perpendiculaires respectives de rangées parallèles (17) et de colonnes parallèles (19), ce procédé comprenant les étapes suivantes :

a) activer une première ligne de rangée (m) associée à des cellules mémoire contenant des données à transférer pour placer sur les lignes de colonne des données à transférer vers des cellules de mémoire associées à une seconde ligne de rangée choisie (m + x) ; et

b) activer une seconde rangée choisie pour recevoir les données en provenance des lignes de colonne pour les transférer aux cellules mémoire associées à la seconde ligne de rangée, caractérisé en ce que ce procédé est appliqué à un dispositif de mémoire dans lequel chacune des lignes de colonne est connectée par une extrémité à l'un d'une pluralité d'amplificateurs de lecture (21) agissant pour amplifier et mémoriser temporairement les données des cellules mémoire correspondantes de la première rangée sélectionnée (m) sur les lignes de colonne associées aux amplificateurs de lecture, chacune des cellules mémoire (15) étant associée à une combinaison unique des lignes de rangées et de colonnes, et en ce que ce procédé comprend en outre, après l'étape a) et avant l'étape b), la mémorisation et l'amplification des données à partir des cellules mémoire de la première ligne de rangée choisie sur les lignes de colonne respectives en utilisant les amplificateurs de lecture (21) du dispositif de mémoire.

2. Procédé selon la revendication 1, dans lequel la première ligne de rangée choisie est désactivée avant d'activer la seconde ligne de rangée choisie.

**Patentansprüche**

1. Verfahren zur Datenübertragung von einer ausgewählten ersten Zeile (m) zu einer ausgewählten zweiten Zeile (m + x) in einer Halbleiterspeichervorrichtung, die ein Feld von Speicherzellen (15) aufweist, die in einer Matrix zueinander orthogonaler, jeweils paralleler Zeilen- (17) und paralleler Spaltenleitungen (19) angeschlossen sind, wobei das Verfahren folgende Schritte beinhaltet:

a) Aktivieren einer ersten Zeilenleitung (m), die Speicherzellen zugeordnet ist, die zu übertragende Daten enthalten, um an Spaltenleitungen Daten anzulegen, die zu Speicherzellen übertragen werden sollen, die einer ausgewählten zweiten Zeilenleitung (m + x) zugeordnet sind; und

b) Aktivieren einer zweiten ausgewählten Zeile, um die Daten von diesen Spaltenleitungen für die Übertragung in die dieser zweiten Zeilenleitung zugeordneten Speicherzellen zu empfangen, **dadurch gekennzeichnet, daß** das Verfahren in einer Speichervorrichtung angewendet wird, in der jede der Spaltenleitungen an einem Ende an einen von mehreren Leseverstärkern (21) zum Verstärken und Speichern der Daten entsprechender Speicherzellen der ausgewählten ersten Zeile (m) auf den diesen Leseverstärkern zugeordneten Spaltenleitungen angeschlossen ist, wobei jede der Speicherzellen (15) einer einzigen Kombination dieser Zeilen- und Spaltenleitungen zugeordnet ist, und daß das Verfahren weiterhin das Speichern und das Verstärken der Daten aus den Speicherzellen der ersten ausgewählten Zeilenleitung auf den entsprechenden Spaltenleitungen durch Benutzung der Leseverstärker (21) dieser Speichervorrichtung nach Schritt a) und vor Schritt b) beinhaltet.

2. Verfahren nach Anspruch 1, bei dem die erste ausgewählte Zeilenleitung vor dem Aktivieren der zweiten ausgewählten Zeilenleitung deaktiviert wird.

FIG. 1

ROW DECODER "m" _18_

ROW DECODER "m + x" _18_

BITLINE "n" _19_

SENSE AMPLIFIER "n" _21_

MEMORY CELL "n m" _15_

MEMORY CELL n(m+x) _15_

BITLINE "n + 1" (OR COLUMNLINE) _19_

SENSE AMPLIFIER "n + 1" _21_

MEMORY CELL (n+1)m _15_

MEMORY CELL (n+1)(m+x) _15_

_13_

ROWLINE "m"

ROWLINE (OR WORDLINE) "m + x"

EP 0 214 050 B1

## FIG. 2

ACTION
OF
SENSE
AMPLIFIERS

ROW "m"

SENSING

LATCHING

ROW "m + x"

$t_0$   $t_1$   $t_2$   $t_3$

## FIG. 3

START — 60

ENABLE
ROW "m" — 50 — $t_0$

SENSE — 52 — $t_1$

LATCH — 53 — $t_2$

ENABLE
ROW "m + x" — 54 — $t_3$

END — 67

6